# EUROPEAN PATENT SPECIFICATION

(11) **EP 0 840 327 B1**
(45) Date of publication and mention of the grant of the patent: **19.03.2003**
(21) Application number: 96830553.2
(22) Date of filing: 30.10.1996
(51) Int. Cl.: G11C 16/06

(54) **Protection circuit for redundancy registers set-up cells of electrically programmable non-volatile memory devices**
Sicherungsschaltung für Initialisierungszellen von Redundanzregistern von elektrisch programmierbaren nichtflüchtigen Speicheranordnungen
Circuit de protection pour cellules d'initialisation pour registres à redondance de dispositifs de mémoires non-volatiles, électriquement programmables

(43) Date of publication of application: 06.05.1998
(73) Proprietor: STMicroelectronics S.r.l., 20041 Agrate Brianza (Milano) (IT)
(72) Inventor: Pascucci, Luigi, 20099 Sesto San Giovanni (Milano) (IT)
(74) Representative: Botti, Mario

(56) References cited:
- US-A- 5 379 249
- IBM TECHNICAL DISCLOSURE BULLETIN, vol. 32, no. 2, July 1989, page 275/276 XP000033424 "TECHNIQUE FOR PREVENTING ACCIDENTAL WRITES TO REPROM MEMORY DURING POWER SEQUENCING"
- PATENT ABSTRACTS OF JAPAN vol. 004, no. 070 (P-012), 23 May 1980 & JP 55 038624 A (SANYO ELECTRIC CO LTD), 18 March 1980,

## Description

### Field of the Invention

This invention relates to a protection circuit for redundancy registers set-up cells of electrically programmable non-volatile memories.

More particularly, the invention relates to a protection circuit as above, which comprises:
- at least one control circuit, being connected between first and second voltage references and having at least an input terminal and an output terminal, said output terminal delivering a reading/programming voltage signal to said redundancy registers; and
- at least one control circuit having a first input terminal for receiving an enabling control signal, a second input terminal for receiving a re-initialisation signal, and an output terminal for supplying a control signal to the first input terminal of the control circuit.

A redundancy register set-up cell is substantially a non-volatile memory cell comprising a floating-gate MOS transistor.

The floating gate is formed on a semiconductor substrate, and is separated therefrom by a thin layer of gate oxide. A control gate is coupled capacitively to the floating gate through a dielectric layer. Metal electrodes are provided to contact the drain, source, and control gate in order to apply predetermined voltage values to the memory cell.

By suitably biasing the cell terminals, the amount of charge in the floating gate can be varied. The operation whereby charge is stored into the floating gate is called "programming phase", and comprises the biasing of the drain terminal and control gate to a predetermined value above the source terminal potential.

A non-volatile memory device provided with redundancy structures usually comprises a large number of such set-up cells. The set-up cells are organised into registers which store the address of a faulty line, row or column. This redundant address should be altered neither by changes in the register operating condition nor by noise affecting the memory device as a whole.

### Prior Art

Prior art memory devices often include redundancy structures to allow rows or columns of the memory matrix to be replaced because found faulty on testing.

In particular, such redundancy structures are connected to set-up registers which contain faulty row/column addresses and corresponding redundant addresses.

Prior redundancy structures and set-up registers have included electrically blown fuses realised by means of non-volatile memory elements adapted to store redundancy and set-up information, as needed for operating the memory, in an unalterable manner.

An electrically blown fuse comprises a suitably unbalanced latching structure which is connected between a first supply voltage reference Vdd and a second voltage reference, such as a signal ground GND, and connected to a set-up memory cell.

Advantageously, the redundancy registers set-up cells comprise, as mentioned above, MOS transistors in like set-up, and accordingly, being dual relatively to the MOS transistors which comprises the memory device.

The register has a first input node at a normally favoured first logic level, or 0 level, and a second input node at an initially favoured second logic level, or 1 level.

The presence of a virgin non-volatile element on the node at the logic 1 level creates a conduction path which upsets the initial condition upon the voltage applied to the control gate of the non-volatile element attaining a suitable conductivity level of the element.

Prior to the memory matrix testing phases, the set-up registers comprise virgin memory cells only.

To store a redundant address, some of the virgin elements of any redundancy register are programmed, sometimes in an imperfect manner which is liable to wear in any case.

When, either at active state or due to incidental causes being not always identifiable, normal levels of the register supply voltage Vdd are exceeded, set-up cells which have been only partially programmed may behave as virgin cells, thereby permanently altering the original redundancy set-up and irreversibly impairing its functionality.

In fact, such partially programmed set-up cells, in the presence of even occasional high levels of the supply voltage Vdd, may trigger conduction paths that should have been cut off upon the programming phase of the cells and which blow off all the same their corresponding electrically blown fuse in the set-up register.

Hence the need to have the set-up cells protected against possible overvoltages of the supply voltage, if malfunctioning of the memory device as a whole is to be prevented.

The underlying technical problem of this invention is to provide a protection circuit for redundancy registers set-up cells of electrically programmable non-volatile memories, which has such structural and functional features as to allow the redundancy registers set-up cells to be disconnected from the supply voltage reference, and this while neither introducing consumption of a static nature nor impairing the operation of the memory at the reading stage.

### Summary of the Invention

The technical problem is solved by a protection circuit for redundancy registers set-up cells of electrically programmable non-volatile memories as previously indicated and defined in the characterising portion of Claims 1 foll. annexed hereto.

The features and advantages of a protection circuit according to the invention will be apparent from the following description of an embodiment thereof, given by way of example and not of limitation with reference to the accompanying drawings.

### Brief Description of the Drawings

In the drawings:
Figure 1 is a schematic representation of a protection circuit realised according to this invention;
Figure 2 is a further schematic view of the protection circuit of Figure 1 in greater detail; and
Figure 3 shows plots vs. time of signals appearing in the protection circuit of Figure 1.

### Detailed Description

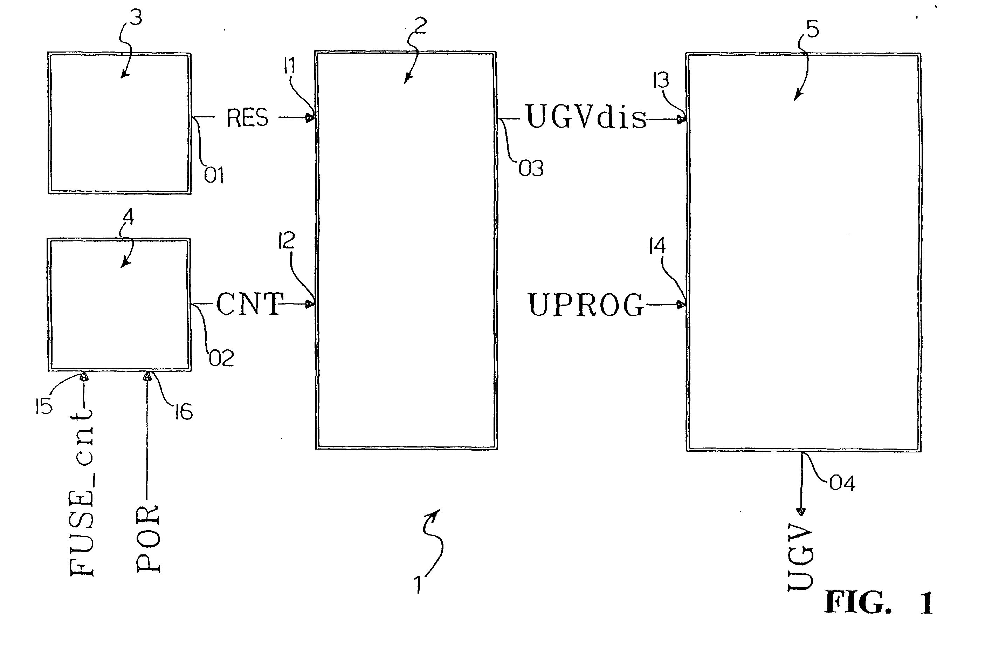

Referring in particular to the example of Figure 1, generally and schematically shown at 1 is a protection circuit realised according to this invention and is intended for set-up cells which are included in redundancy registers, e.g. cells of the UPROM type.

The protection circuit 1 comprises a bistable circuit 2 which is deliberately unbalanced and has a first input terminal I1 connected to an output terminal O1 of a disabling circuit 3, a second input terminal I2 connected to an output terminal 02 of a control circuit 4, and an output terminal 03 connected to a first input terminal I3 of a control circuit 5.

The control circuit 5 has a second input terminal I4 which receives a program enabling signal UPROG, and an output terminal 04 which delivers a reading voltage signal, and concurrently therewith a programming signal UGV, where required, to the set-up cells. The first input terminal I3 of the control circuit 5 receives a disabling signal UGVdis.

In addition, the control circuit 4 has first I5 and second I6 input terminals to respectively receive a control enabling signal FUSE_cnt and a Power-on-Reset signal POR, and delivers a control signal CNT on the output terminal O2.

Finally, the output terminal O1 of the disabling circuit 3 delivers a disabling signal RES.

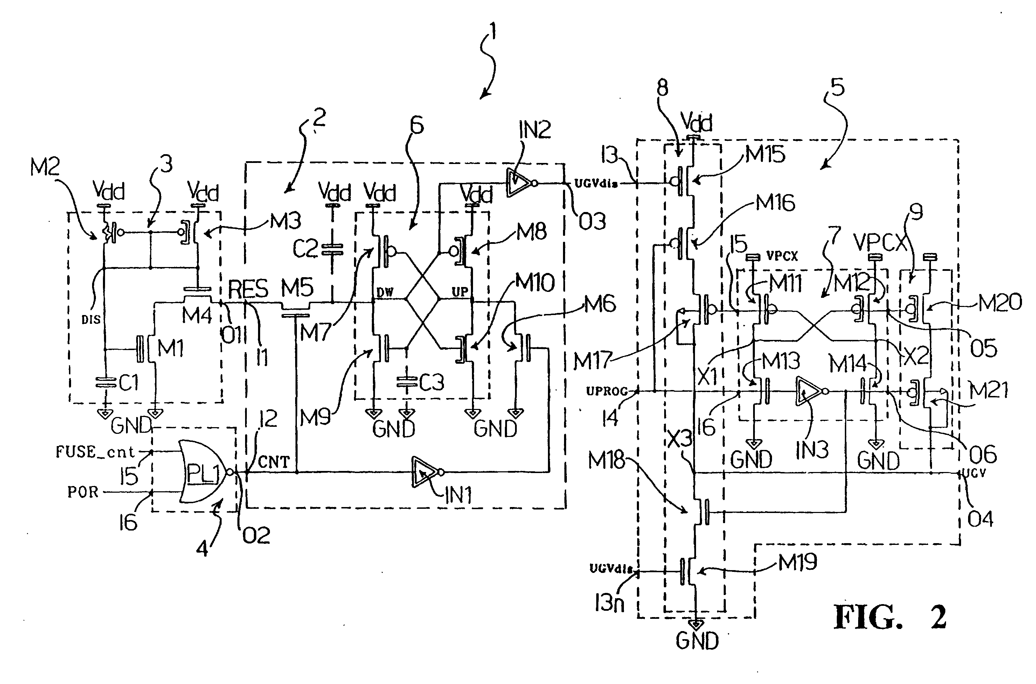

The circuit portions incorporated to the protection circuit 1, shown in Figure 2, will now be described with more regard to their structural details.

According to the invention, the disabling circuit 3 advantageously includes a redundant memory element M1.

More particularly, the redundant memory element M1 of Figure 2 is a floating-gate MOS transistor substantially similar to the memory cells which are connected to the protection circuit 1, specifically to the output terminal 04 of the control circuit 5.

The disabling circuit 3 also includes a compensation transistor M2 and a pull-up transistor M3 to a first supply voltage reference Vdd, which transistors M2 and M3 are connected between the supply voltage reference Vdd and a translated supply voltage reference DIS and have their control terminals connected to each other, to their respective drain terminals, and to the translated supply voltage reference DIS.

The disabling circuit 3 further includes a decoupling transistor M4 connected to the output terminal O1 of the disabling circuit 3 and to a second voltage reference, specifically a signal ground GND, via the redundant memory element M1. The decoupling transistor M4 also has a control terminal connected to the translated supply voltage reference DIS.

In addition, the disabling circuit 3 includes a capacitor C1 which is connected between the translated supply voltage reference DIS and the ground GND, and connected to the control terminal of the redundant memory element M1.

In the embodiment shown in Figure 2, the compensation transistor M2 is a P-channel MOS transistor, or PMOS, with high resistivity, the pull-up transistor M3 is a native type PMOS transistor, and the decoupling transistor M4 is an N-channel MOS transistor, or NMOS.

The control circuit 4 comprises a logic gate PL1 which has a first input terminal I5 to receive the control enabling signal FUSE_cnt, a second input terminal I6 to receive the Power-on-Reset signal POR, and an output terminal O2 delivering a control signal CNT and being connected to the second input terminal I2 of the bistable circuit 2.

The control enabling signal FUSE_cnt is operative to cut off the protection circuit 1.

In the embodiment shown in Figure 2, the logic gate PL1 is a NOR gate.

The bistable circuit 2 comprises a flip-flop 6 which is connected between the supply voltage reference Vdd and the ground GND and has an input terminal DW and an output terminal UP, respectively connected to the first I1 and second I2 input terminals of the bistable circuit 2.

In particular, the input terminal DW of the flip-flop 6 is connected to the first input terminal I1 of the bistable circuit 2 via an input transistor M5 which has a control terminal connected to the second input terminal I2 of the bistable circuit 2. Also, the input terminal DW of the flip-flop 6 may optionally be connected to the supply voltage reference Vdd via a capacitor C2, thereby to enhance the flip-flop unbalance.

On the other hand, the output terminal UP is connected to the ground GND via an output transistor M6 which has a control terminal connected to the second input terminal I2 of the bistable circuit 2 via a logic inverter IN1.

The flip-flop 6 comprises first M7 and second M8 transistors connected between the supply voltage reference Vdd and respectively the input terminal DW and the output terminal UP, and comprises third M9 and fourth M10 transistors respectively connected between the input terminal DW and the output terminal UP and the ground GND.

In particular, the first M7 and third M9 transistors have their control terminals connected together and to the output terminal UP, as well as to the ground GND through an optional capacitor C3, while the second M8 and fourth M10 transistors have their control terminals connected together and to the input terminal DW, as well as to the output terminal 03 of the bistable circuit 2 through a logic inverter IN2.

In the embodiment shown in Figure 2, the input transistor M5 and the output transistor M6 of the bistable circuit 2 are NMOS transistors, the first transistor M7 of the flip-flop 6 is a PMOS transistor, the second transistor M8 is a native PMOS transistor, the third transistor M9 is an NMOS transistor, and the fourth transistor M10 is a native NMOS transistor.

The control circuit 5 comprises a voltage booster circuit 7 connected between a programming voltage reference VPCX and the ground GND, and to the input I3, I4, I3n and output 04 terminals of the control circuit 5, respectively through an input decoupling circuit 8 and an output decoupling circuit 9.

In particular, the booster circuit 7 includes first M11 and second M12 transistors which are connected between the programming voltage reference VPCX and respective first X1 and second X2 internal circuit nodes, and third M13 and fourth M14 transistors which are connected between the first X1 and second X2 internal circuit nodes and the ground GND, respectively.

Furthermore, the first M11 and second M12 transistors have their respective control terminals connected to the first X1 and second X2 internal circuit nodes, and their respective bulk terminals connected to a first input terminal I5 and a first output terminal 05 of the booster circuit 7.

On the other hand, the third M13 and fourth M14 transistors, have their respective control terminals connected together through a logic inverter IN3 and respective bulk terminals connected to a second input terminal I6 and a second output terminal O6 of the booster circuit 7.

The input decoupling circuit 8 is connected between the supply voltage reference Vdd and the ground GND, and comprises a series of first M15, second M16 and third M17 input decoupling transistors which are connected between the supply voltage reference Vdd and an internal circuit node X3, and a series of fourth M18 and fifth M19 input decoupling transistors which are connected between the internal circuit node X3 and the ground GND.

In particular, the first input decoupling transistor M15 has a control terminal connected to the first input terminal I3 of the control circuit 5, the second input decoupling transistor M16 has a control terminal connected to the second input terminal I4, and the third input decoupling transistor M17 has a control terminal connected to the first input terminal I5 of the booster circuit 7.

Also, the fourth input decoupling transistor M18 has a control terminal connected to the control terminal of the fourth transistor M14 of the booster circuit 7, and the fifth input decoupling transistor M19 has a control terminal connected to a complementary input terminal I3n of the control circuit 5.

The output decoupling circuit 9 is connected between the programming voltage reference VPCX and the output terminal O4 of the control circuit 5, and comprises first M20 and second M21 output decoupling transistors which have respective control terminals connected to the first O5 and second O6 output terminals of the booster circuit 7.

In the embodiment shown in Figure 2, the first transistor M11 of the booster circuit 7 is a PMOS transistor, the second transistor M12 is a native PMOS transistor, and the third M13 and fourth M14 transistors are NMOS transistors.

Also, the first M15, second M16 and third M17 input decoupling transistors of the input decoupling circuit 8 are PMOS transistors, with the third transistor M17 being in particular in diode configuration, while the fourth M18 and fifth M19 input decoupling transistors are NMOS transistors.

Finally, the first M20 and second M21 output decoupling transistors are native PMOS transistors.

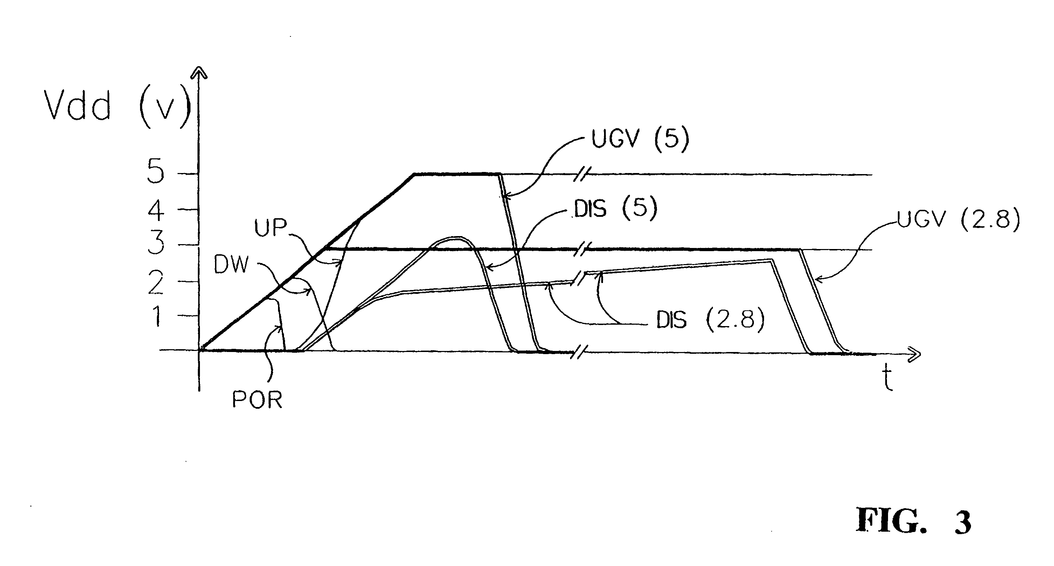

The operation of the protection circuit 1 according to the invention will now be described with reference in particular to the signal plots shown in Figure 3.

It will be assumed that the protection circuit 1 is to be connected to a cell of an electrically programmable non-volatile memory device, specifically of the UPROM type, not shown in Figure 1 because known.

The disabling circuit 3, which includes the redundant memory element M1, responds in a similar manner to the memory cell having the circuit 1 connected thereto, the circuit 3 being identical with that cell and only generating the disabling signal RES when this is actually needed.

The protection circuit 1 operates during the transient phase of application of the supply voltage to the memory device to be protected.

In the presence of the Power-on-Reset signal POR, the bistable circuit 2 ("UPROM-like") is preset by the presence of a logic 0 level on its output terminal UP and a logic 1 level on its input terminal DW.

The bistable circuit 2 is, moreover, isolated from the natural reset path of the disabling circuit 3 by means of the input transistor M5 being kept 'off' by the control signal CNT delivered by the control circuit 4.

At the end of the Power-on-Reset pulse, the bistable circuit 2, being deliberately unbalanced, is no longer driven to the presetting condition, and is simultaneously connected to the reset path of the disabling circuit 3 by the signal RES.

According to the invention, while the redundancy registers set-up memory cells are connected to the supply voltage Vdd from the start, the redundant memory element M1 of the disabling circuit 3, being a repetition of such set-up cells, is applied the translated supply voltage DIS as derived from the supply voltage Vdd by pulling the drain terminal of the pull-up transistor M3.

The voltage DIS is only dynamically translated relatively to the supply voltage Vdd. In fact, the pull-up transistor M3 has a high conductivity that readily pulls the capacitor C1 of the disabling circuit 3, restricting its swing to below the supply voltage for a value equal to the threshold voltage of a native PMOS transistor, i.e. about -1.6V. Thus, a value Vdd-Vth_pch_nat is obtained for the translated supply voltage.

The compensation transistor M2 has instead a lower threshold, of about -1.1V, and is highly resistive, it only operating in the asymptotical end portion of the supply voltage pattern, so as to ensure that the protection circuit is triggered on even at minimal levels of the supply voltage.

Accordingly, the disabling circuit 3 is basically a repetition of the set-up cell to be protected, but is connected to the translated supply voltage reference DIS.

When the translated supply voltage DIS meets the conditions for triggering on the redundant memory element M1, the disabling signal UGVdis is activated.

In particular, the decoupling transistor M4 of the disabling circuit 3 is applied a voltage equal to the supply voltage Vdd less the value of the threshold voltage Vth_pch_nat of the PMOS transistor M3, which will couple the input terminal DW of the flip-flop 6 to the translated supply voltage DIS being applied to the redundant memory element M1.

Upon this translated supply voltage DIS reaching a value that will reverse the flip-flop 6, the bistable circuit 2 supplies the disabling signal UGVdis to disable the booster circuit 7 and lead the reading/programming voltage signal UGV to ground.

In this way, the series of the bistable circuit 2 and the control circuit 5 will function as a network driven by the redundant memory element M1 to prevent overvoltages in the supply voltage Vdd from being propagated to the memory cells, and ensure their proper operation.

It matters to remark that the booster circuit 7 is, during normal operation of the memory device, definitely in a reversed condition, since the memory cells to which it is connected are supplied the supply voltage Vdd, sure to be higher than the voltage being applied to the redundant memory element M1 and equal to Vdd-Vth_pch.

Thus, it will be the protection circuit 1 to realise by itself that an initialisation is being performed on the memory cells whereto it is connected.

Furthermore, the booster circuit 7 is deliberately strongly unbalanced to prevent any incidental pulses.

With the bistable circuit 2 being triggered on at fairly low levels of the translated supply voltage DIS, the voltage to the redundant memory element M1, through lying above that value and precisely equal to DIS+Vth_pch_nat, will cut off the application of the supply voltage Vdd to the set-up cells before it can attain dangerous levels.

On the other hand, at low supply levels, the pull-up transistor M3 pulling will be unable to trigger on the redundant memory element M1. In this case, the compensation transistor M2 is first operated which has a lower threshold and is suitably dimensioned to be highly resistive and, hence, very slow; the redundant memory element M1 will therefore be triggered on at a level of the translated supply voltage DIS which lies closer to the supply voltage Vdd.

Accordingly, the pulse will be spread more, and hold the supply voltage applied for a longer time.

Lastly, at very low supply levels, the "leakage" phenomenon of the compensation M2 and pull-up M3 transistors will operate to take the value of the supply voltage Vdd to the memory cells which are connected to the protection circuit 1, albeit at a very slow rate.

This huge extension of the protection circuit triggering time does not endanger the redundancy registers and ensures that they are read correctly even at very low levels of the supply voltage Vdd.

Keeping the operation of the protection circuit 1 driven by the supply voltage even at very low levels, albeit for a much protracted time, is made possible by the provision of PMOS compensation and pull-up transistors, M2 and M3, and by the utilisation of the leakage current from their P junctions.

It is important to observe that this pulling-up, though asymptotical of the supply voltage, is possible on account of the translated supply voltage DIS node having no N-channel junctions connected to it. The "leakage" phenomenon, as tied to possible N-channel junctions, would indeed oppose the operation of the compensation transistor M2, and therefore inhibit pulling-up to the supply voltage and, with it, triggering on the protection circuit at low levels of the supply voltage.

The reversal of the booster circuit 7 is self-compensated, in the sense that, at low levels of the supply voltage, the booster circuit reversing would be retarded, whereas at high levels of the voltage, the operational condition would be advanced, thereby ensuring that the complete reading from the non-volatile memory elements can be carried up at all times.

Thus, the risk of resetting programmed cells is avoided, because the reading voltage signal UGV is controlled in a self-compensated manner by the disabling signal UGVdis driving a logic 0 level on the signal UGV as soon as the memory device having the protection circuit 1 applied to it can be regarded as fully read, based on that the bistable circuit 2 would replicate its behaviour. It can be stated, therefore, that the protection circuit 1 as a whole is self-compensated relatively to the supply voltage Vdd.

The programming voltage signal UGV is controlled by means of the control circuit 5 being input the program enabling signal UPROG and allowing the voltage UGV to be raised to the value of the programming voltage VPCX (usually about 12V).

Under normal conditions, the program enabling signal UPROG would be at a low logic level, or 0 level, and inhibit all programming activities, and the second input decoupling transistor M16 would be in the 'on' state.

With the disabling signal UGVdis at the 0 level, the first input decoupling transistor M15 is 'on' and the third transistor M13 of the booster circuit 7 is 'off'. In this way, the control terminal of the fourth transistor M14 of the booster circuit 7 will have its control terminal at a high logic level, or 1 level, and drives the second internal circuit node X2 to the 0 level, thereby turning off the second transistor M12 of the booster circuit 7 and the first output decoupling transistor M20.

Under such conditions, the reading/programming voltage signal UGV will be following the supply voltage reference Vdd through the input decoupling transistors M15, M16 and M17, presently all in the 'off' state.

As the disabling signal UGVdis goes to the 1 level, the first input decoupling transistor M15 is turned off, and the fifth input decoupling transistor M19 is turned on to drive a 0 level on the reading/programming voltage signal UGV.

Thus, the input decoupling transistors M15, M16 and M17 control the reading/programming voltage signal UGV for normal operation of the memory device to which the circuit 1 is connected.

During the memory cell programming phase, the program enabling signal UPROG goes to the 1 level, thereby driving the first internal circuit node X1 to the 0 level, and the second internal circuit node X2 to the 1 level. In this way, the output decoupling transistors M20 and M21 will be turned on, and the reading/programming voltage signal UGV connected to the programming voltage reference VPCX, higher than the supply voltage reference Vdd.

The output decoupling transistors M20 and M21 will then control the reading/programming voltage signal UGV during the programming operations of the memory device having the circuit 1 connected thereto.

According to the invention, the second transistor M12 of the booster circuit 7 and the first output decoupling transistor M20 advantageously are of the native type, thus allowing the protection circuit 1 to be slowed down during transients. This slowing down of the circuit 1 guards the memory cells which are connected to the circuit from incidental programming, as due for example to sudden electrostatic charges, so that the behaviour of the reading/programming voltage signal UGV remains unaffected by such charges.

In addition, the slowed reading/programming voltage signal UGV avoids incidental alteration of the contents of the memory cells to which it is delivered.

On the other hand, with the Power-on-Reset signal POR present, the flip-flop 6 would be driven into a reverse condition and the signal UGV would go to a high level substantially corresponding to the supply voltage Vdd.

The bistable circuit 2, which is repeating by construction the behaviour of a redundancy register generic set-up cell, and the control circuit 5 operate, therefore, as one system to control the reading/programming voltage signal UGV, thereby allowing the set-up cells to be applied the supply voltage Vdd to a definitely sufficient extent for them to be correctly read, and disabling this supply voltage as soon as a correct reading is surely obtained.

The protection circuit 1 of this invention improves the safety of the data in the memory cells connected to it even on the occurrence of fluctuations in the supply voltage during the reading phase.

Thus, the protection circuit 1 of this invention can set the time, level and extension of the reading/programming voltage signal UGV, as shown in Figure 3 for different values of the supply voltage Vdd, without using external signals or any special initial set-up.

The benefits brought about by the use of the protection circuit 1 of this invention, can be summarised as follows:
- generation of a pulsate reading/programming voltage signal UGV for the redundancy registers set-up cells whereto the circuit 1 is connected;
- self-disconnection of such memory cells from the supply voltage once they have been read, only upon the redundant memory element M1 being triggered on;
- inhibition of the propagation, through the protection circuit 1 to the memory cells, of voltage spikes and high critical levels of the supply voltage Vdd;
- removal of any stress condition at high voltages from the memory cells to which the circuit 1 is connected; and
- assurance of proper operation of the protection device even at very low levels of the supply voltage.

It should be understood that changes and modifications may be made unto the protection circuit 1 according to the invention within the scope of the following claims.

## Claims

1. A protection circuit (1) for redundancy registers set-up cells of electrically programmable non-volatile memories, of the type which comprises:
- at least one control circuit (5), being connected between first (Vdd) and second (GND) voltage references and having at least an input terminal (I3) and an output terminal (O4), said output terminal (O4) delivering a reading/programming voltage signal (UGV) to said cells; and
- at least one control circuit (4) having a first input terminal (I5) for receiving an enabling control signal (FUSE_cnt), a second input terminal (I6) for receiving a Power-on-Reset signal (POR), and an output terminal (O2) for supplying a control signal (CNT) to the first input terminal (I3) of the control circuit (5);
**characterised in that** it further comprises:
- a disabling circuit (3), being connected between the first (Vdd) and the second voltage reference (GND) and having an output terminal (O1) connected to the first input terminal (I3) of the control circuit (5), which comprises at least one redundant memory element (M1) connected between a translated voltage reference (DIS) and the second voltage reference (GND).

2. A protection circuit (1) according to Claim 1, **characterised in that** said disabling circuit (3) further comprises at least one pull-up transistor (M3) connected between the first voltage reference (Vdd) and the translated voltage reference (DIS).

3. A protection circuit (1) according to Claim 1, **characterised in that** said redundant memory element (M1) has a control terminal connected to the second voltage reference (GND) through a capacitor (C1).

4. A protection circuit (1) according to Claim 2, **characterised in that** it comprises a further resistive compensation transistor (M2) being connected between the first voltage reference (Vdd) and the translated voltage reference (DIS) and having a control terminal connected to a control terminal of said pull-up transistor (M3) and to the translated voltage reference (DIS).

5. A protection circuit (1) according to Claim 1, **characterised in that** it comprises a bistable circuit (2), being connected between the first (Vdd) and the second voltage reference (GND) and having a first input terminal (I1) connected to the output terminal (O1) of the disabling circuit (3), a second input terminal (I2) connected to the output terminal (O2) of the control circuit (4), and an output terminal (O3) connected to the first input terminal (I3) of the control circuit (5), said bistable circuit (2) comprising at least one flip-flop element (6) connected between the first (Vdd) and the second voltage reference (GND), and connected to the first (I1) and second (I2) input terminals, and to the output terminal (O3) of the bistable circuit (2), the bistable circuit (2) being similar in structure to the redundancy registers set-up cells to which the protection circuit is attached.

6. A protection circuit (1) according to Claim 5, **characterised in that** said flip-flop (6) has an input terminal (DW) connected to the first input terminal (I1) of the bistable circuit (2) through an input transistor (M5), and to the first voltage reference (Vdd) through a capacitor (C2), and has an output terminal (UP) connected to the second voltage reference (GND) through an output transistor (M6) having a control terminal connected to the second input terminal (I2) of the bistable circuit (2).

7. A protection circuit (1) according to Claim 1, **characterised in that** the control circuit (5) has a further input terminal (I4) for receiving a program enabling signal (UPROG).

8. A protection circuit (1) according to Claim 7, **characterised in that** the control circuit (5) includes a voltage booster circuit (7) connected between a programming voltage reference (VPCX) and the second voltage reference (GND), and connected to the input terminal (I3), to the further input terminal (I4) and to the output terminal (O4) of the control circuit (5), said programming voltage reference (VPCX) being at a higher level than the first voltage reference (Vdd).

9. A protection circuit (1) according to Claim 2, **characterised in that** the pull-up transistor (M3) is a highly conductive, P-channel MOS transistor of the native type.

10. A protection circuit (1) according to Claim 4, **characterised in that** the compensation transistor (M2) is a highly resistive, P-channel MOS transistor effective to slow down the protection circuit (1) transients.

11. A protection circuit (1) according to Claim 1, **characterised in that** the redundant memory element (M1) is a floating-gate MOS transistor substantially similar to the set-up cells connected to the protection circuit.

12. A protection circuit (1) according to Claim 4, **characterised in that** it includes a decoupling transistor (M4) being connected between the output terminal (O1) of the disabling circuit (3) and the redundant memory element (M1) and having a control terminal connected to the dynamically-only translated voltage reference (DIS).

13. A protection circuit (1) according to Claim 6, **characterised in that** said input transistor (M5) has a control terminal connected to the second input terminal (I2) of the bistable circuit (2), and said output transistor (M6) has a control terminal connected to the second input terminal (I2) of the bistable circuit (2) through a logic inverter (IN1).

14. A protection circuit (1) according to Claim 5, **characterised in that** the flip-flop (6) comprises first (M7) and second (M8) transistors connected between the first voltage reference (Vdd) and respectively the input (DW) and output (UP) terminals of the flip-flop (6), and third (M9) and fourth (M10) transistors respectively connected between the input (DW) and output (UP) terminals of the flip-flop (6) and the second voltage reference (GND), the first (M7) and third (M9) transistors having their control terminals connected together and to the output terminal (UP), and to the second voltage reference (GND) through a capacitor (C3), and the second (M8) and fourth (M10) transistors having their control terminals connected together, to the input terminal (DW), and to the output terminal (O3) of the bistable circuit (2) through a logic inverter (IN2).

15. A protection circuit (1) according to Claim 8, **characterised in that** the voltage booster circuit (7) is connected to the input terminal (I3), to the further input terminal (I4), and to the output terminal (04) of the control circuit (5), respectively through an input decoupling circuit (8) connected between the first (Vdd) and the second voltage reference (GND), and an output decoupling circuit (9) connected between the programming voltage reference (VPCX) and the output terminal (04) of the control circuit (5).

16. A protection circuit (1) according to Claim 15, **characterised in that** the voltage booster circuit (7) comprises first (M11) and second (M12) transistors connected between the programming voltage reference (VPCX) and respectively first (X1) and second (X2) internal circuit nodes, and comprises third (M13) and fourth (M14) transistors, respectively connected between the first (X1) and second (X2) internal circuit nodes and the second voltage reference (GND), said first (M11) and second (M12) transistors having their respective control terminals connected to the first (X1) and second (X2) internal circuit nodes, and having their respective bulk terminals connected to a first input terminal (I5) and to a first output terminal (05) of the voltage booster circuit (7), and said third (M13) and fourth (M14) transistors having their respective control terminals connected together through a logic inverter (IN3) and having their respective bulk terminals connected to a second input terminal (I6) and to a second output terminal (O6) of the voltage booster circuit (7).

17. A protection circuit (1) according to Claim 16, **characterised in that** the input decoupling circuit (8) comprises a series of first (M15), second (M16) and third (M17) input decoupling transistors connected between the first voltage reference (Vdd) and an internal circuit node (X3), and a series of fourth (M18) and fifth (M19) input decoupling transistors connected between the internal circuit node (X3) and the second voltage reference (GND), said first (M15), second (M16) and third (M17) input decoupling transistors having their respective control terminals connected to the first (I3) and the second (I4) input terminal of the control circuit (5) and to the first input terminal (I5) of the voltage booster circuit (7), said fourth (M18) and fifth (M19) input decoupling transistors having their respective control terminals connected to the control terminal of the fourth transistor (M14) of the voltage booster circuit (7) and to a complementary input terminal (I3n) of the control circuit (5).

18. A protection circuit (1) according to Claim 16, **characterised in that** the output decoupling circuit (9) comprises first (M20) and second (M21) output decoupling transistors having their respective control terminals connected to the first (O5) and the second (O6) output terminal of the voltage booster circuit (7).

19. A protection circuit (1) according to Claim 18, **characterised in that** the first (M20) and second (M21) output decoupling transistors are P-channel MOS transistors of the native type.

## Patentansprüche

1. Schutzschaltung (1) für Initialisierungszellen von Redundanzregistern von elektrisch programmierbaren nichtflüchtigen Speichern der Bauart, die folgendes umfasst:
- mindestens eine Steuerschaltung (5), die zwischen der ersten (Vdd) und zweiten (GND) Vergleichsspannung verbunden ist und mindestens einen Eingangsanschluss (13) und einen Ausgangsanschluss (O4) aufweist, wobei der Ausgangsanschluss (O4) ein Lese/Programmier-Spannungssignal (UGV) an die Zellen liefert; und
- mindestens eine Steuerschaltung (4), die einen ersten Eingangsanschluss (15) zum Empfangen eines Freigabe-Steuersignals (FUSE_cnt), einen zweiten Eingangsanschluss (I6) zum Empfangen eines Energie-beim-Zurücksetzen-Signals (POR) und einen Ausgangsanschluss (O2) zum Abgeben eines Steuersignals (CNT) an den ersten Eingangsanschluss (13) der Steuerschaltung (5) aufweist;
**dadurch gekennzeichnet, dass** sie weiter folgendes umfasst:
- eine Sperrschaltung (3), die zwischen der ersten (Vdd) und der zweiten Vergleichsspannung (GND) angeschlossen ist und einen Ausgangsanschluss (O1) aufweist, der mit dem ersten Eingangsanschluss (I3) der Steuerschaltung (5) verbunden ist, die mindestens ein redundantes Speicherelement (M1) umfasst, das zwischen einer umgewandelten Vergleichsspannung (DIS) und der zweiten Vergleichsspannung (GND) angeschlossen ist.

2. Schutzschaltung (1) nach Anspruch 1, **dadurch gekennzeichnet, dass** die Sperrschaltung (3) weiter mindestens einen Pull-up-Transistor (M3) aufweist, der zwischen der ersten Vergleichsspannung (Vdd) und der umgewandelten Vergleichsspannung (DIS) angeschlossen ist.

3. Schutzschaltung (1) nach Anspruch 1, **dadurch gekennzeichnet, dass** das redundante Speicherelement (M1) einen Steueranschluss aufweist, der über einen Kondensator (C1) an die zweite Vergleichsspannung (GND) angeschlossen ist.

4. Schutzschaltung (1) nach Anspruch 2, **dadurch gekennzeichnet, dass** sie einen weiteren widerstandsbehafteten Kompensationstransistor (M2) aufweist, der zwischen der ersten Vergleichsspannung (Vdd) und der umgewandelten Vergleichsspannung (DIS) angeschlossen ist und einen Steueranschluss aufweist, der mit einem Steueranschluss des Pullup-Transistors (M3) und mit der umgewandelten Vergleichsspannung (DIS) verbunden ist.

5. Schutzschaltung (1) nach Anspruch 1, **dadurch gekennzeichnet, dass** sie eine bistabile Schaltung (2) umfasst, die zwischen der ersten (Vdd) und der zweiten Vergleichsspannung (GND) angeschlossen ist und einen ersten Eingangsanschluss (I1), der mit dem Ausgangsanschluss (O1) der Sperrschaltung (3) verbunden ist, einen zweiten Eingangsanschluss (12), der mit dem Ausgangsanschluss (O2) der Steuerschaltung (4) verbunden ist, und einen Ausgangsanschluss (O3), der mit dem ersten Eingangsanschluss (I3) der Steuerschaltung (5) verbunden ist, aufweist, wobei die bistabile Schaltung (2) mindestens ein Flipflop-Element (6) umfasst, das zwischen der ersten (Vdd) und der zweiten Vergleichsspannung (GND) angeschlossen und mit dem ersten (I1) und zweiten (I2) Eingangsanschluss sowie mit dem Ausgangsanschluss (O3) der bistabilen Schaltung (2) verbunden ist, wobei die bistabile Schaltung (2) vom Aufbau her ähnlich den Initialisierungszellen von Redundanzregistern ist, an der die Schutzschaltung angebracht ist.

6. Schutzschaltung (1) nach Anspruch 5, **dadurch gekennzeichnet, dass** der Flipflop (6) einen Eingangsanschluss (DW) aufweist, der über einen Eingangstransistor (M5) an den ersten Eingangsanschluss (I1) der bistabilen Schaltung (2) und über einen Kondensator (C2) an die erste Vergleichsspannung (Vdd) angeschlossen ist und einen Ausgangsanschluss (UP) aufweist, der an die zweite Vergleichsspannung (GND) über einen Ausgangstransistor (M6) angeschlossen ist, der einen Steueranschluss aufweist, der mit dem zweiten Eingangsanschluss (I2) der bistabilen Schaltung (2) verbunden ist.

7. Schutzschaltung (1) nach Anspruch 1, **dadurch gekennzeichnet, dass** die Steuerschaltung (5) einen weiteren Eingangsanschluss (14) zum Empfangen eines Programm-Freigabesignals (UPROG) aufweist.

8. Schutzschaltung (1) nach Anspruch 7, **dadurch gekennzeichnet, dass** die Steuerschaltung (5) eine Spannungsverstärkerschaltung (7) aufweist, die zwischen einer Programmiervergleichsspannung (VPCX) und der zweiten Vergleichsspannung (GND) angeschlossen ist sowie mit dem Eingangsanschluss (13), dem weiteren Eingangsanschluss (14) und dem Ausgangsanschluss (O4) der Steuerschaltung (5) verbunden ist, wobei sich die Programmiervergleichsspannung (VPCX) auf einem höheren Niveau als die erste Vergleichsspannung (Vdd) befindet.

9. Schutzschaltung (1) nach Anspruch 2, **dadurch gekennzeichnet, dass** der Pull-up-Transistor (M3) ein hochleitender P-Kanal-MOS-Transistor der spezifischen Bauart ist.

10. Schutzschaltung (1) nach Anspruch 4, **dadurch gekennzeichnet, dass** der Kompensationstransistor (M2) ein äußerst widerstandsbehafteter P-Kanal-MOS-Transistor ist, der dahingehend wirksam ist, dass er die Einschwingungsvorgänge der Schutzschaltung (1) verlangsamt.

11. Schutzschaltung (1) nach Anspruch 1, **dadurch gekennzeichnet, dass** das redundante Speicherelement (M1) ein Schwebegate-MOS-Transistor ist, der im wesentlichen ähnlich den Initialisierungszellen ist, die mit der Schutzschaltung verbunden sind.

12. Schutzschaltung (1) nach Anspruch 4, **dadurch gekennzeichnet, dass** er einen Entkopplungstransistor (M4) aufweist, der zwischen dem Ausgangsanschluss (O1) der Sperrschaltung (3) und dem redundanten Speicherelement (M1) angeschlossen ist und einen Steueranschluss aufweist, der mit der nur dynamisch umgewandelten Vergleichsspannung (DIS) verbunden ist.

13. Schutzschaltung (1) nach Anspruch 6, **dadurch gekennzeichnet, dass** der Eingangstransistor (M5) einen Steueranschluss aufweist, der mit dem zweiten Eingangsanschluss (12) der bistabilen Schaltung (2) verbunden ist, und der Ausgangstransistor (M6) einen Steueranschluss aufweist, der über einen logischen Inverter (IN1) an den zweiten Eingangsanschluss (I2) der bistabilen Schaltung (2) angeschlossen ist.

14. Schutzschaltung (1) nach Anspruch 5, **dadurch gekennzeichnet, dass** der Flipflop (6) einen ersten (M7) und zweiten (M8) Transistor, die zwischen der ersten Vergleichsspannung (Vdd) und dem Eingangsanschluss (DW) bzw. Ausgangsanschluss (UP) des Flipflops (6) angeschlossen sind, sowie einen dritten (M9) und vierten (M10) Transistor umfasst, die zwischen dem Eingangsanschluss (DW) bzw. Ausgangsanschluss (UP) des Flipflop (6) und der zweiten Vergleichsspannung (GND) angeschlossen sind, wobei der erste (M7) und dritte (M9) Transistor über ihre Steueranschlüsse aneinander und an den Ausgangsanschluss (UP) und über einen Kondensator (C3) an die zweite Vergleichsspannung (GND) angeschlossen sind, und der zweite (M8) und vierte (M10) Transistor über ihre Steueranschlüsse aneinander, an den Eingangsanschluss (DW) und über einen logischen Inverter (IN2) an den Ausgangsanschluss (O3) der bistabilien Schaltung (2) angeschlossen sind.

15. Schutzschaltung (1) nach Anspruch 8, **dadurch gekennzeichnet, dass** die Spannungsverstärkerschaltung (7) an den Eingangsanschluss (I3), an den weiteren Eingangsanschluss (I4) und an den Ausgangsanschluss (O4) der Steuerschaltung (5) angeschlossen ist, und zwar jeweils über eine Eingangs-Entkopplungsschaltung (8), die zwischen der ersten (Vdd) und zweiten Vergleichsspannung (GND) angeschlossen ist, bzw. über eine Ausgangs-Entkoppelungsschaltung (9), die zwischen der Programmiervergleichsspannung (VPCX) und dem Ausgangsanschluss (04) der Steuerschaltung (5) angeschlossen ist.

16. Schutzschaltung (1) nach Anspruch 15, **dadurch gekennzeichnet, dass** die Spannungsverstärkerschaltung (7) einen ersten (M11) und zweiten (M12) Transistor umfasst, die zwischen der Programmiervergleichsspannung (VPCX) und jeweils dem ersten (X1) bzw. zweiten (X2) internen Schaltungsknoten angeschlossen sind, sowie einen dritten (M13) und vierten (M14) Transistor, die jeweils zwischen dem ersten (X1) bzw. zweiten (X2) internen Schaltungsknoten und der zweiten Vergleichsspannung (GDN) angeschlossen sind, umfasst, wobei der erste (M11) und zweite (M12) Transistor über ihre entsprechenden Steueranschlüsse an den ersten (X1) und zweiten (X2) internen Schaltungsknoten angeschlossen sind und über ihre entsprechenden Massenanschlüsse an einen ersten Eingangsanschluss (I5) und an einen ersten Ausgangsanschluss (05) der Spannungsverstärkerschaltung (7) angeschlossen sind, und der dritte (M13) und vierte (M14) Transistor über ihre entsprechenden Steueranschlüsse über einen logischen Inverter (IN3) zusammengeschlossen sind und über ihre entsprechenden Massenanschlüsse an einen zweiten Eingangsanschluss (16) und an einen zweiten Ausgangsanschluss (06) der Spannungsverstärkerschaltung (7) angeschlossen sind.

17. Schutzschaltung (1) nach Anspruch 16, **dadurch gekennzeichnet, dass** die Eingangsentkopplungsschaltung (8) eine Reihe von ersten (M15), zweiten (M16) und dritten (M17) Eingangsentkopplungstransistoren, die zwischen der ersten Vergleichsspannung (Vdd) und einem internen Schaltungsknoten (X3) angeschlossen sind, und eine Reihe von vierten (M18) und fünften (M19) Eingangsentkopplungstransistoren, die zwischen dem internen Schaltungsknoten (X3) und der zweiten Vergleichsspannung (GND) angeschlossen sind, umfasst, wobei der erste (M15), zweite (M16) und dritte (M17) Eingangsentkopplungstransistor über ihre entsprechenden Steueranschlüsse mit dem ersten (13) und zweiten (14) Eingangsanschluss der Steuerschaltung (5) und mit dem ersten Eingangsanschluss (15) der Spannungsverstärkerschaltung (7) verbunden sind, wobei der vierte (M18) und fünfte (M19) Eingangsentkopplungstransistor über ihre entsprechenden Steueranschlüsse mit dem Steueranschluss des vierten Transistors (M14) der Spannungsverstärkerschaltung (7) und mit einem komplementären Eingangsanschluss (I3n) der Steuerschaltung (5) verbunden sind.

18. Schutzschaltung (1) nach Anspruch 16, **dadurch gekennzeichnet, dass** die Ausgangsentkopplungsschaltung (9) einen ersten (M20) und zweiten (M21) Ausgangsentkopplungstransistor umfasst, die über ihre entsprechenden Steueranschlüsse mit dem ersten (O5) und dem zweiten (O6) Ausgangsanschluss der Spannungsverstärkerschaltung (7) verbunden sind.

19. Schutzschaltung (1) nach Anspruch 18, **dadurch gekennzeichnet, dass** der erste (M20) und zweite (M21) Ausgangsentkopplungstransistor P-Kanal-MOS-Transistoren der spezifischen Bauart sind.

## Revendications

1. Circuit de protection (1) pour cellules d'initialisation pour registre à redondance de dispositifs de mémoires non volatiles électriquement programmables comprenant :
- au moins un circuit de commande (5), connecté entre une première (Vdd) et une deuxième (GND) tension de référence et disposant d'au moins une borne d'entrée (I3) et une borne de sortie (O4), ladite borne de sortie (O4) fournissant un signal de tension de lecture/de programmation (UGV) auxdites cellules ; et
- au moins un circuit de commande (4) dont une première borne d'entrée (I5) est destinée à recevoir un signal de déclenchement de commande (FUSE_cnt), une deuxième borne d'entrée (I6) à recevoir un signal de Mise sous tension-Réinitialisation (POR) et une borne de sortie (O2) pour fournir un signal de commande (CNT) à la première borne d'entrée (13) du circuit de commande (5).
Ce circuit de protection comprend en outre :
- un circuit de mise hors tension (3) connecté entre la première (Vdd) et la deuxième références de tension (GND) et disposant d'une borne de sortie (O1) connectée à la première borne d'entrée (13) du circuit de commande (5), qui comprend au moins un élément de mémoire redondant (M1) connecté entre une tension de référence convertie (DIS) et la deuxième tension de référence (GND).

2. Circuit de protection (1) selon la revendication 1, **caractérisé en ce que** ledit circuit de mise hors tension (3) comprend en outre au moins un transistor de charge (M3) connecté entre la première tension de référence (Vdd) et la tension de référencé convertie (DIS).

3. Circuit de protection (1) selon la revendication 1, **caractérisé en ce que** ledit élément de mémoire redondant (M1) dispose d'une borne de commande connectée à la deuxième tension de référence (GND) par le biais d'un condensateur (C1).

4. Circuit de protection (1) selon la revendication 2, **caractérisé en ce qu'**il comprend un transistor de compensation résistif (M2) supplémentaire connecté entre la première tension de référence (Vdd) et la tension de référence convertie (DIS), et dont l'une des bornes de commande est connectée à une borne de commande dudit transistor de charge (M3) et à la tension de référence convertie (DIS).

5. Circuit de protection (1) selon la revendication 1, **caractérisé en ce qu'**il comprend un circuit bistable (2) connecté entre la première (Vdd) et la deuxième tension de référence (GND), et dont une première borne d'entrée (I1) est connectée à la borne de sortie (O1) du circuit de mise hors tension (3), une deuxième borne d'entrée (I2) est connectée à la borne de sortie (O2) du circuit de commande (4), et une borne de sortie (O3) est connectée à la première borne d'entrée (I3) du circuit de commande (5), ledit circuit bistable (2) comprenant au moins une bascule (6) connectée entre les première (Vdd) et deuxième références de tension (GND), et connecté aux première (I1) et deuxième (I2) bornes d'entrée, et à la borne de sortie (O3) du circuit bistable (2), la structure du circuit bistable (2) étant semblable à celle des cellules d'initialisation pour registre à redondance auxquelles le circuit de protection est attaché.

6. Circuit de protection (1) selon la revendication 5, **caractérisé en ce que** ladite bascule (6) dispose d'une borne d'entrée (DW) connectée à la première borne d'entrée (I1) du circuit bistablte (2) par le biais d'un transistor d'entrée (M5), et à la première tension de référence (Vdd) par le biais d'un condensateur (C2), et dispose d'une borne de sortie (UP) connectée à la deuxième tension de référence (GND) par le biais d'un transistor de sortie (M6) dont une borne de commande est connectée à la deuxième borne d'entrée (12) du circuit bistable (2).

7. Circuit de protection (1) selon la revendication 1, **caractérisé en ce que** le circuit de commande (5) dispose d'une borne d'entrée supplémentaire (I4) pour recevoir un signal de déclenchement de programme (UPROG).

8. Circuit de protection (1) selon la revendication 7, **caractérisé en ce que** le circuit de commande (5) comprend un circuit amplificateur de tension (7) connecté entre une tension de référence de programmation (VPCX) et la deuxième tension de référence (GND), et connecté à la borne d'entrée (I3), à la borne d'entrée supplémentaire (I4) et à la borne de sortie (O4) du circuit de commande (5), ladite tension de référence de programmation (VPCX) étant supérieure à la première tension de référence (Vdd).

9. Circuit de protection (1) selon la revendication 2, **caractérisé en ce que** le transistor de charge (M3) est un transistor MOS à canal P très conducteur de type natif.

10. Circuit de protection (1) selon la revendication 4, **caractérisé en ce que** le transistor de compensation (M2) est un transistor MOS à canal P très résistif permettant de ralentir les phénomènes transitoires du circuit de protection (1).

11. Circuit de protection (1) selon la revendication 1, **caractérisé en ce que** l'élément de mémoire redondant (M1) est un transistor MOS à grille flottante en grande partie semblable aux cellules de positionnement connectées au circuit de protection.

12. Circuit de protection (1) selon la revendication 4, **caractérisé en ce qu'**il comprend un transistor de découplage (M4) connecté entre la borne de sortie (O1) du circuit de mise hors tension (3) et l'élément de mémoire redondant (M1), et dont une borne de commande est connectée à la tension de référence convertie (DIS) de façon dynamique uniquement.

13. Circuit de protection (1) selon la revendication 6, **caractérisé en ce que** l'une des bornes de commande dudit transistor d'entrée (M5) est connectée à la deuxième borne d'entrée (I2) du circuit bistable (2), et l'une des bornes de commande dudit transistor de sortie (M6) est connectée à la deuxième borne d'entrée (I2) du circuit bistable (2) par le biais d'un inverseur logique (IN1).

14. Circuit de protection (1) selon la revendication 5, **caractérisé en ce que** la bascule (6) comprend un premier (M7) et un deuxième (M8) transistors connectés entre la première tension de référence (Vdd) et respectivement les bornes d'entrée (DW) et de sortie (UP) de la bascule (6), et un troisième (M9) et un quatrième (M10) transistors respectivement connectés entre les bornes d'entrée (DW) et de sortie (UP) de la bascule (6) et la deuxième tension de référence (GND), les bornes de commande des premier (M7) et troisième (M9) transistors étant connectées entre elles et à la borne de sortie (UP), ainsi qu'à la deuxième tension de référence (GND) par le biais d'un condensateur (C3), et les bornes de commande des deuxième (M8) et quatrième (M10) transistors étant connectées entre elles, à la borne d'entrée (DW) ainsi qu'à la borne de sortie (O3) du circuit bistable (2) par le biais d'un inverseur logique (IN2).

15. Circuit de protection (1) selon la revendication 8, **caractérisé en ce que** le circuit amplificateur de tension (7) est connecté à la borne d'entrée (I3), à la borne d'entrée supplémentaire (I4) et à la borne de sortie (O4) du circuit de commande (5), respectivement par le biais d'un circuit de découplage d'entrée (8) connecté entre la première (Vdd) et la deuxième tension de référence (GND), et un circuit de découplage de sortie (9) connecté entre la tension de référence de programmation (VPCX) et la borne de sortie (04) du circuit de commande (5).

16. Circuit de protection (1) selon la revendication 15, **caractérisé en ce que** le circuit amplificateur de tension (7) comprend un premier (M11) et un deuxième (M12) transistors connectés entre la tension de référence de programmation (VPCX) et respectivement les premier (X1) et deuxième (X2) noeuds de circuit internes, et comprend les troisième (M13) et quatrième (M14) transistors, respectivement connectés entre les premier (X1) et deuxième (X2) noeuds de circuit internes et la deuxième tension de référence (GND), les bornes de commande respectives des premier (M11) et deuxième (M12) transistors sont connectées aux premier (X1) et deuxième (X2) noeuds de circuit internes, et leurs borne de charge respectives sont connectés à une première borne d'entrée (I5) et à une première borne de sortie (O5) du circuit amplificateur de tension (7), et les bornes de commande respectives desdits troisième (M13) et quatrième (M14) transistors sont connectées entre elles par le biais d'un inverseur logique (IN3) et leurs bornes de charge respectives sont connectés à une deuxième borne d'entrée (16) et à une deuxième borne de sortie (O6) du circuit amplificateur de. tension (7) .

17. Circuit de protection (1) selon la revendication 16, **caractérisé en ce que** le circuit de découplage d'entrée (8) comprend d'une part un premier (M15), un deuxième (M16) et un troisième (M17) transistors de découplage d'entrée connectés entre la première tension de référence (Vdd) et un noeud de circuit interne (X3), et d'autre part un quatrième (M18) et un cinquième (M19) transistors de découplage d'entrée connectés entre le noeud de circuit interne (X3) et la deuxième tension de référence (GND), les bornes de commande respectives desdits premier (M15), deuxième (M16) et troisième (M17) transistors de découplage d'entrée sont connectées aux première (I3) et deuxième (I4) bornes d'entrée du circuit de commande (5) et à la première borne d'entrée (I5) du circuit amplificateur de tension (7), les bornes de commande respectives desdits quatrième (M18) et cinquième (M19) transistors de découplage d'entrée sont connectées à la borne de commande du quatrième transistor (M14) du circuit amplificateur de tension (7) et à une borne d'entrée complémentaire (I3n) du circuit de commande (5).

18. Circuit de protection (1) selon la revendication 16, **caractérisé en ce que** le circuit de découplage de sortie (9) comprend un premier (M20) et un deuxième (M21) transistors de découplage de sortie dont les bornes de commande respectives sont connectées aux première (O5) et deuxième (O6) bornes de sortie du circuit amplificateur de tension (7).

19. Circuit de protection (1) selon la revendication 18, **caractérisé en ce que** les. premier (M20) et deuxième (M21) transistors de découplage de sortie sont des transistors MOS à canal P de type natif.
